Europäisches Patentamt

European Patent Office

Office européen des brevets

(19)

(11) Publication number:

**0 343 898**
**A2**

(12) **EUROPEAN PATENT APPLICATION**

(21) Application number: **89305154.0**

(22) Date of filing: **22.05.89**

(51) Int. Cl.⁴: **H03K 5/00**

(30) Priority: **23.05.88 JP 126899/88**

(43) Date of publication of application:
**29.11.89 Bulletin 89/48**

(84) Designated Contracting States:
**AT BE CH DE ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Itoh, Tatsuo**
**11-53 Hachiman-cho 2 chome**
**Higashikurume-shi Tokyo(JP)**

(74) Representative: **Wright, Hugh Ronald et al**
**Brookes & Martin 52/54 High Holborn**
**London WC1V 6SE(GB)**

(54) Frequency multiplying circuit.

(57) A circuit for multiplying the frequency of a train of input pulses of a given frequency and of a duty cycle of 50%, comprising
means responsive to the input pulses for generating a ramp signal having a ramp portion formed as a function of the repetition of the input pulses,
Exclusive OR logic means for evaluating an Exclusive OR logic of said input pulses and the output from said ramp signal generating means,
means coupled from the output of said Exclusive OR logic means to the input of said Exclusive OR logic means for integrating and feeding back the output of said Exclusive OR logic means to the input of said Exclusive OR logic means in addition to the output from said ramp signal generating means, and
means coupled to said integrating and feeding back means for determining a direct current level of the integrated and fedback signal for causing the duty cycle of the output from said Exclusive OR logic means to be 50%.

EP 0 343 898 A2

## Frequency Multiplying Circuit

The present invention generally relates to a frequency multiplying circuit and more specifically relates to a frequency multiplying circuit for providing a train of pulses of the doubled frequency and the duty cycle of 50% in response to a train of input pulses of a given frequency and of the duty cycle of 50%.

Semiconductor ships for microcomputers, microprocessors or the like are operated as a function of a train of clock pulses. For example, a semiconductor chip for a microcomputer currently available in market as referred to as "80286" requires a train of clock pulses of the frequency of 30MHz. However, a crystal oscillator adapted for 30MHz is hardly available and expensive. Therefore, it is desirable a clock signal generator of a frequency as 30MHz should be available using a crystal oscillator of a lower frequency currently available in market with a less expensive cost and using frequency multiplication.

A typical frequency multiplier for clock pulses usually employs a phase locked loop technology. However, employment of a phase locked loop necessitates a voltage controlled oscillator, a phase comparator, a frequency divider and the like, which makes a circuit configuration complicated and expensive.

Another type of frequency multiplier employs an Exclusive OR logic circuit adapted to receive input pulses at one input thereto and to receive at the other input an integrated output of the input pulses integrated with a predetermined time constant, provided that the duty cycle of the input pulses is 50%. Assuming that the duty cycle of the input pulses is 50% and the time constant of the integration is properly selected, a frequency doubled output can be obtained with the duty cycle of 50%. However, if and when the frequency of the input pulses fluctuates, the duty cycle of the frequency doubled output is accordingly changeable, which makes it impossible to use the frequency multiplier as a clock pulse source for semiconductor chips.

We will describe a frequency multipying circuit for multiplying the frequency of the input pulses to provide an output of a down frequency and of a controlled duty cycle of 50%, irrespective of fluctuation of the input frequency.

We will describe a frequency multiplying circuit which makes it possible to generate a train of pulses of a higher frequency through frequency multiplication with less complicacy and less cost.

We will describe a clock pulse generating circuit for generating train of clock pulses of a predetermined duty cycle of 50% and of a doubled frequency in response to a train of input pulses of a given frequency and of a duty cycle of 50%.

Briefly described, the present invention provides a circuit for multiplying the frequency of a train of input pulses of a given frequency and of a duty cycle of 50%, comprising means responsive to the input pulses for generating a ramp signal having a ramp portion formed as a function of the repetition of the input pulses, Exclusive OR logic means for evaluating an Exclusive OR logic of said input pulses and the output from said ramp signal generating means, means coupled from the output of said Exclusive OR logic means to the input of said Exclusive OR logic means for integrating and feeding back the output of said Exclusive OR logic means to the input of said Exclusive OR logic means in addition to the output from said ramp signal generating means, and means coupled to said integrating and feeding back means for determining a direct current level of the integrated and fed back signal for causing the duty cycle of the output from said Exclusive OR logic means to be 50%. from the following detailed description of the present invention when taken in conjunction with the accompanying drawings.

BRIEF DESCRIPTION OF THE DRAWINGS

Fig. 1 is a block diagram showing the principle of the inventive frequency multiplying circuit;

Fig. 2 is a schematic diagram of one embodiment of the inventive frequency multiplying circuit; and

Fig. 3 is a graph showing the waveforms of the signals at various portions in the circuit shown in Fig. 2.

DESCRIPTION OF THE PREFERRED EMBODIMENT

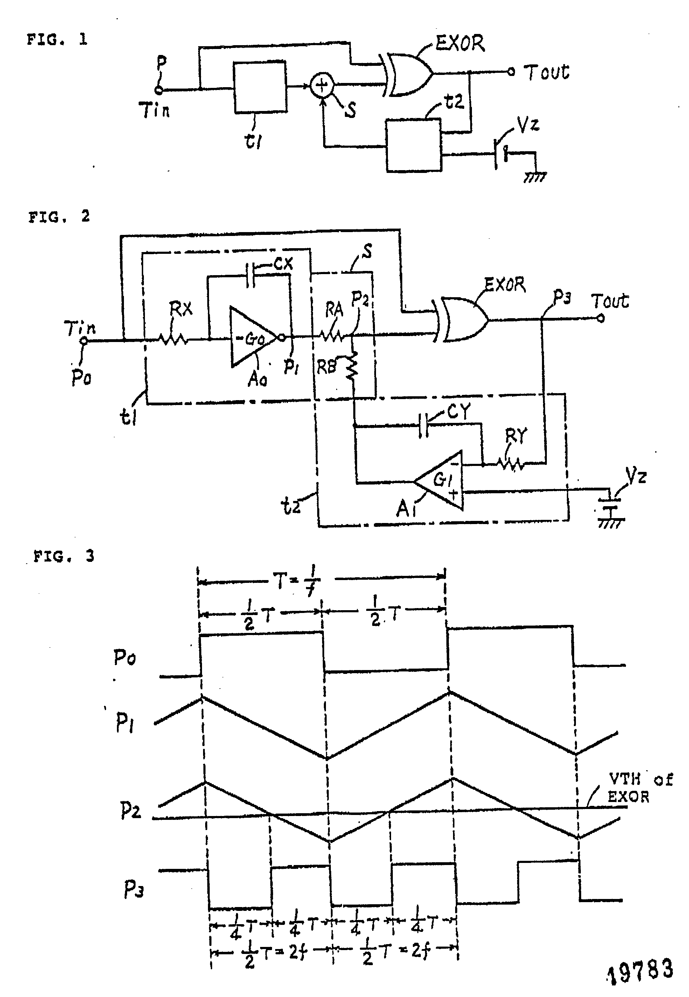

Fig. 1 is a block diagram showing the principle of the inventive frequency multiplying circuit. The frequency multiplying circuit shown in Fig. 1 comprises an input terminal Tin receiving a train of input pulses of a given frequency and a duty cycle of 50%, a ramp signal generating circuit t1 coupled to the input terminal Tin for generating a ramp signal having a ramp portion formed as a function of the repetition of the input pulses, a summing circuit S coupled to the output of the ramp signal generating circuit t1 for summing the output from the ramp signal generating circuit t1 and another input to be described subsequently, an Exclusive OR logic circuit EXOR connected to receive at one input the input pulses and to receive at the other input the output from the summing circuit S, an integrating and feeding back circuit t2 for integrating the output from the Exclusive OR logic circuit EXOR and feeding back through the summing circuit S the integrated output to the other input of the Exclusive OR logic circuit, and a reference voltage source V2 for adjusting the direct current level of the integrated output so that the duty cycle of the output from the Exclusive OR logic circuit EXOR may be 50%, and an output terminal Tout coupled to the output of the Exclusive OR logic circuit EXOR.

In operation, evaluation of the Exclusive OR logic of the input pulses of a given frequency and a duty cycle of 50% and the ramp signal generated by the ramp signal generating circuit t1 produces a train of pulses of a doubled frequency and a duty cycle of 50% in case of proper selection of the reference voltage applied to the feedback loop.

Fig. 2 is a schematic diagram of the embodiment of the inventive frequency multiplying circuit embodying the principle of the invention shown in Fig. 1. The ramp signal generating circuit t1 comprises an amplifier A0 of a gain -G0, an input resistor RX and a capacitor CX, constituting an integrating circuit. The summing circuit S comprises a connection of a resistor RA connected from output of the ramp signal generating circuit t1 and a resistor RB connected from the output of the integrating and feeding back circuit t2. The integrating and feeding back circuit t2 comprises an operational amplifier A1 of a gain G1 receiving at the inverting input the output from the Exclusive OR gate EXOR, an input resistor RY connected from the output of the Exclusive OR gate EXOR and a capacitor CY connected between the inverting input and output of the operational amplifier A1. The reference voltage source $V_Z$ is connected to the non-inverting input of the operational amplifier A1. The input terminal Tin is connected to receive a train of input pulses of a given frequency and a duty cycle of 50% and is connected to one input of the Exclusive OR gate EXOR and the input of the ramp signal generating circuit t1. The output from the Exclusive OR gate EXOR is connected to the output terminal Tout.

As operation of the circuit shown in Fig. 2 is better understood with reference to Fig. 3, which shows a graph showing the waveforms of the signals at various portions in the circuit shown in Fig. 2. A train of the input pulses PO is directly supplied to the Exclusive OR gate EXOR and is also applied to the input of the ramp signal generating circuit t1. The ramp signal generating circuit t1 integrates the input pulses to convert the same to an output P1 of a triangle waveform. When the triangle waveform output P1 is applied to the Exclusive OR gate EXOR, the output from the Exclusive OR gate EXOR is integrated by the resistor RY and the capacitor CY and the operational amplifier A1 and the integrated output is fed back to the Exclusive OR gate EXOR through the resistor RB. The time constant of the resistor RY and the capacitor CY is selected to be sufficiently large as compared with the input pulse period (1/Fin = T). Therefore, the output from the integrating and feeding back circuit may be considered as a direct current component. In other words, the triangle waveform output P1 fed through the resistor RA is biased with the direct current component supplied through the resistor RB.

Assuming that the output voltage of the high level from the Exclusive OR gate EXOR is $V_{OH}$, the period of the high level of the output is $t_{OH}$, the output voltage of the low level of the output is $V_{LA}$, and the period of the low level of the output is $t_{OL}$, then the following equations are obtained with respect to the reference voltage $V_Z$ applied to the non-inverting input of the operational amplifier A1.

In case that the voltage at the point PO is the high level,

$$(V_{OH} \times t_{OH}) + (V_{OL} \times t_{OL}) = V_Z \qquad (1)$$

In case that the voltage at the point P is the low level

$$(V_{OH} \times t_{OL}) + (V_{OL} \times t_{OH}) = V_Z \qquad (2)$$

$$t_{OL} + t_{OH} = \tfrac{1}{2} T - 2f \qquad (3)$$

Assuming that the Exclusive OR gate EXOR is implemented with complimentary MOS integrated circuits, then the values of the output voltages $V_{OH}$ and $V_{OL}$ from the Exclusive OR gate EXOR are known and also stable. Therefore, the duty cycle of the output from the Exclusive OR gate EXOR is determined as a function of the reference voltage $V_Z$ irrespective of the frequency of the input pulses. Accordingly, if and when the reference voltage $V_Z$ is adjusted so that the duty cycle of the output from the Exclusive OR gate EXOR may be 50%, then the voltages at various portions P0, P1, P2, P3 in the circuit shown in Fig. 2 are as shown in Fig. 3.

Assuming that the gain G1 of the operational amplifier A1 is sufficiently large and an error at the differential inputs is stable, a fluctuation of the threshold voltage $V_{TH}$ and a fluctuation of delay time in the amplifier A0 and the Exclusive OR gate EXOR during a longer period of time can be neglected because of integration by the operational amplifier A1, the capacitor CY and the resistor RY. In addition, the magnitude of the frequency Fin of the input pulses is merely related with the amplitude of the triangle waveform output obtained at the output P1 of the amplifier A0 and, therefore, assuming that the gain G1 of the amplfier A1 is sufficiently large, the duty cycle of the output from the Exclusive OR gate EXOR is not influenced by the magnitude of the frequency Fin.

Thus, if and when a train of the input pulses of any frequency Fin and of a duty cycle of 50% is applied, a train of the output pulses of a doubled frequency 2Fin and of a duty cycle of 50% is thus obtained. Therefore, by using a plurality (N) of the same frequency multiplying circuit as described above, a train of pulses of a frequency 2N x Fin and of a duty cycle of 50% is obtained.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A circuit for multiplying the frequency of a train of input pulses of a given frequency and of a duty cycle of 50%, comprising
means responsive to the input pulses for generating a ramp signal having a ramp portion formed as a function of the repetition of the input pulses,
Exclusive OR logic means for evaluating an Exclusive OR logic of said input pulses and the output from said ramp signal generating means,
means coupled from the output of said Exclusive OR logic means to the input of said Exclusive OR logic means for integrating and feeding back the output of said Exclusive OR logic means to the input of said Exclusive OR logic means in addition to the output from said ramp signal generating means, and
means coupled to said integrating and feeding back means for determining a direct current level of the integrated and fedback signal for causing the duty cycle of the output from said Exclusive OR logic means to be 50%.

FIG. 1

FIG. 2

FIG. 3

19783